(19) Europäisches Patentamt / European Patent Office / Office européen des brevets

(11) **EP 4 348 828 B1**

(12) **EUROPEAN PATENT SPECIFICATION**

(45) Date of publication and mention
of the grant of the patent:
**06.08.2025 Bulletin 2025/32**

(21) Application number: **21731103.4**

(22) Date of filing: **03.06.2021**

(51) International Patent Classification (IPC):
*H03F 3/24* (2006.01)    *H03F 1/32* (2006.01)
*H04B 7/0452* (2017.01)    *H03F 3/68* (2006.01)

(52) Cooperative Patent Classification (CPC):
**H04B 7/0452; H03F 1/3241; H03F 3/24; H03F 3/68**

(86) International application number:
**PCT/EP2021/064898**

(87) International publication number:
**WO 2022/253438 (08.12.2022 Gazette 2022/49)**

(54) **DETERMINATION OF DIGITAL PRE-DISTORTER SIZE OF AN ACCESS NODE**

GRÖSSENBESTIMMUNG EINES ZUGANGSKNOTEN DIGITALEN VORVERZERRERS

DÉTERMINATION DE LA TAILLE D'UN DISPOSITIF DE PRÉDISTORSION NUMÉRIQUE D'UN NOEUD D'ACCÈS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**10.04.2024 Bulletin 2024/15**

(73) Proprietor: **Telefonaktiebolaget LM Ericsson (publ)**
**164 83 Stockholm (SE)**

(72) Inventors:
• **SHEIKHI, Ashkan**
 **226 44 LUND (SE)**
• **EDFORS, Ove**
 **247 36 SÖDRA SANDBY (SE)**
• **RUSEK, Fredrik**
 **241 35 ESLÖV (SE)**

(74) Representative: **Ericsson Patent Development**
**Torshamnsgatan 21-23**
**164 80 Stockholm (SE)**

(56) References cited:
• **TARVER CHANCE ET AL: "OFDM-Based Beam-Oriented Digital Predistortion for Massive MIMO", 2019 IEEE INTERNATIONAL SYMPOSIUM ON CIRCUITS AND SYSTEMS (ISCAS), IEEE, 22 May 2021 (2021-05-22), pages 1 - 5, XP033932963, ISSN: 2158-1525, ISBN: 978-1-7281-3320-1, [retrieved on 20210412], DOI: 10.1109/ ISCAS51556.2021.9401479**
• **LIU YING ET AL: "Digital Predistortion for MIMO Transmitters Using Multi-Channel Error Feedback Adaptation", IEEE ACCESS, IEEE, USA, vol. 8, 17 November 2020 (2020-11-17), pages 209345 - 209355, XP011823137, DOI: 10.1109/ACCESS.2020.3038941**

EP 4 348 828 B1

**Description**

**TECHNICAL FIELD**

Embodiments presented herein relate to a method, an access node, a computer program, and a computer program product for DPD size determination of the access node.

**BACKGROUND**

Multi-antenna techniques can significantly increase the data rates and reliability of a wireless communication system. The performance is in particular improved if both the transmitter and the receiver are equipped with multiple antennas, which results in a multiple-input multiple-output (MIMO) communication channel. Such systems and/or related techniques are commonly referred to as MIMO systems, or just MIMO for short.

Massive MIMO, in which the number of antennas at the access node (AN) scales up by one or more orders of magnitude, has emerged as a new technology to replace conventional multi-user MIMO. This enhancement enables the system to exploit spatial multiplexing and serve a large number of user equipment (UEs) using the same time and frequency resources. In turn, this can improve the spectral efficiency by orders of magnitude. The success of massive MIMO technology to improve the system performance can be large when fully digital beamforming is adopted at the access node. Fully digital beamforming requires one radio frequency (RF) chain per antenna. In this respect, high-quality RF ends consume relatively high amounts of power, in addition to being expensive. Therefore, there might be some scenarios where the use of high-quality RF ends should be avoided. Further, when the number of antennas at the AN grows large, the digital beamforming complexity and RF chain power consumption also grow large which, in practice, limits the scaling.

Deploying a massive MIMO system with an arbitrarily large number of antennas thus introduces practical challenges to be resolved. These challenges make the achieved gains in the system performance when deploying massive MIMO systems to be far away from what theory suggests. This is mainly due to non-ideal effects of the hardware in the access node. In this respect, one of the main sources of distortion in a communication system in general, and in the access node in particular, is the non-linear behavior of amplifiers, such as power amplifiers (PAs), in the transceiver chains.

Digital predistortion (DPD) is known as an effective technique to mitigate the non-linear distortions in the output of amplifiers. In massive MIMO systems, due to the large number of antennas at the access node, adopting a MIMO DPD scheme commonly results in high complexity. In turn, this introduces challenges in the implementation, see for example K. Hausmair, P. N. Landin, U. Gustavsson, C. Fager, and T. Eriksson, "Digital predistortion for multi-antenna transmitters affected by antenna crosstalk," IEEE Transactions on Microwave Theory and Techniques, vol. 66, no. 3, pp. 1524-1535, 2018. Therefore, deploying per-antenna DPDs is a more practical technique for massive MIMO systems.

Based on the measurements in realistic environments which implements a massive MIMO system, the contribution of each antenna to the system capacity is not equal due to large-scale variations across the array of antennas. In this respect, as used throughout this document, large-scale variations in this context refer to variations across antennas within the array, not to variations across time. This implies that MIMO DPD should be used at the access node. However, MIMO DPDs are complex to implement and consume a high level of power when in operation. This is especially true when the number of antennas grows large.

Hence, there is still a need for improved configuration of DPDs intended for operation in a massive MIMO system.

TARVER CHANCE ET AL, "OFDM-Based Beam-Oriented Digital Predistortion for Massive MIMO", 2019 IEEE INTERNATIONAL SYMPOSIUM ON CIRCUITS AND SYSTEMS (ISCAS), IEEE, doi:10.1109/ISCAS51556.2021.9401479, ISSN 2158-1525, ISBN 978-1-7281-3320-1, (20210522), pages 1 - 5, (20210412), XP033932963 relates to access nodes comprising a MIMO digital DPD.

LIU YING ET AL, "Digital Predistortion for MIMO Transmitters Using Multi-Channel Error Feedback Adaptation", IEEE ACCESS, IEEE, USA, (20201117), vol. 8, doi:10.1109/ACCESS.2020.3038941, pages 209345 - 209355, XP011823137 also relates to DPD.

**SUMMARY**

An object of embodiments herein is to distribute the coefficients of the DPDs among the per-antenna DPDs in a way that contributes to good, or even optimum, overall system performance.

According to a first aspect there is presented a method for DPD size determination of an access node. The access node is configured for operation in a digital massive MIMO system. The access node comprises a plurality of antennas, one radio chain per antenna, and one DPD per radio chain. The method is performed by the access node. The method comprises obtaining channel gain estimates per each of the plurality of antennas. The method comprises determining the size, in terms of number of coefficients, of each DPD according to a utility function that depends on the channel gain estimates per antenna. The method comprises allocating the determined number of coefficients to each DPD.

According to a second aspect there is presented an access node for DPD size determination of the access node. The access node is configured for operation in a digital massive MIMO system. The access node comprises a plurality of antennas, one radio chain per antenna, and one DPD per radio chain. The access node comprises processing circuitry. The processing circuitry is configured to cause the access node to obtain channel gain estimates per each of the plurality of antennas. The processing circuitry is configured to cause the access node to determine the size, in terms of number of coefficients, of each DPD according to a utility function that depends on the channel gain estimates per antenna. The processing circuitry is configured to cause the access node to allocate the determined number of coefficients to each DPD.

According to a third aspect there is presented an access node for DPD size determination of the access node. The access node is configured for operation in a digital massive MIMO system. The access node comprises a plurality of antennas, one radio chain per antenna, and one DPD per radio chain. The access node comprises an obtain module configured to obtain channel gain estimates per each of the plurality of antennas. The access node comprises a determine module configured to determine the size, in terms of number of coefficients, of each DPD according to a utility function that depends on the channel gain estimates per antenna. The access node comprises an allocate module configured to allocate the determined number of coefficients to each DPD.

According to a fourth aspect there is presented a computer program for DPD size determination of an access node, the computer program comprising computer program code which, when run on the access node, causes the access node to perform a method according to the first aspect.

According to a fifth aspect there is presented a computer program product comprising a computer program according to the fourth aspect and a computer readable storage medium on which the computer program is stored. The computer readable storage medium could be a non-transitory computer readable storage medium.

Advantageously, these aspects enable the DPD budget (i.e., the size, in terms of number of coefficients) to be used efficiently. In turn, this can enhance the system energy efficiency, and the overall system performance.

Advantageously, as a result of the proposed efficient DPD size selection, these aspects enable the gap between high-power consuming MIMO DPDs and low-performance per-antenna DPDs to be narrowed. The herein disclosed aspects thus provide an intermediate solution to DPDs in massive MIMO systems, between immensely complexity and high-performing MIMO DPDs and low-complexity but low-performing uniform per-antenna DPDs.

Advantageously, as a result of the proposed efficient DPD size selection, the resources for the DPDs can be used in the most efficient way, improving system performance at the same total level of DPD power consumption or, alternatively, maintaining system performance whilst reducing DPD power consumption, compared to standard and uniform per-antenna DPDs.

Advantageously, these aspects enable power and/or energy resources used for DPDs in massive MIMO systems to be used more efficiently. In this respect, the power consumed in the DPD block can be used efficiently and the system can decrease its overall power consumption and still have the same performance as in the case without DPD optimization. Further in this respect, the system capacity can be improved without increasing the DPD power consumption, which results in a higher system energy-efficiency.

Advantageously, the gain achieved by adapting the DPD size allows the use of less expensive RF hardware and reduce the system overall cost, which becomes more critical as massive MIMO systems grow.

Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, module, step, etc." are to be interpreted openly as referring to at least one instance of the element, apparatus, component, means, module, step, etc., unless explicitly stated otherwise. The steps of any method disclosed herein do not have to be performed in the exact order disclosed, unless explicitly stated.

## BRIEF DESCRIPTION OF THE DRAWINGS

The inventive concept is now described, by way of example, with reference to the accompanying drawings, in which:

Fig. 1 is a schematic diagram illustrating a communications network according to embodiments;

Fig. 2 is a schematic block diagram of an access node according to an embodiment;

Figs. 3 and 4 are flowcharts of methods according to embodiments;

Fig. 5 shows simulation results according to embodiments;

Fig. 6 is a schematic diagram showing functional units of an access node according to an embodiment;

Fig. 7 is a schematic diagram showing functional modules of an access node according to an embodiment; and

Fig. 8 shows one example of a computer program product comprising computer readable storage medium according to an embodiment.

## DETAILED DESCRIPTION

The inventive concept will now be described more fully hereinafter with reference to the accompanying drawings, in which certain embodiments of the inventive concept are shown. This inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description. Any step or feature illustrated by dashed lines should be regarded as optional.

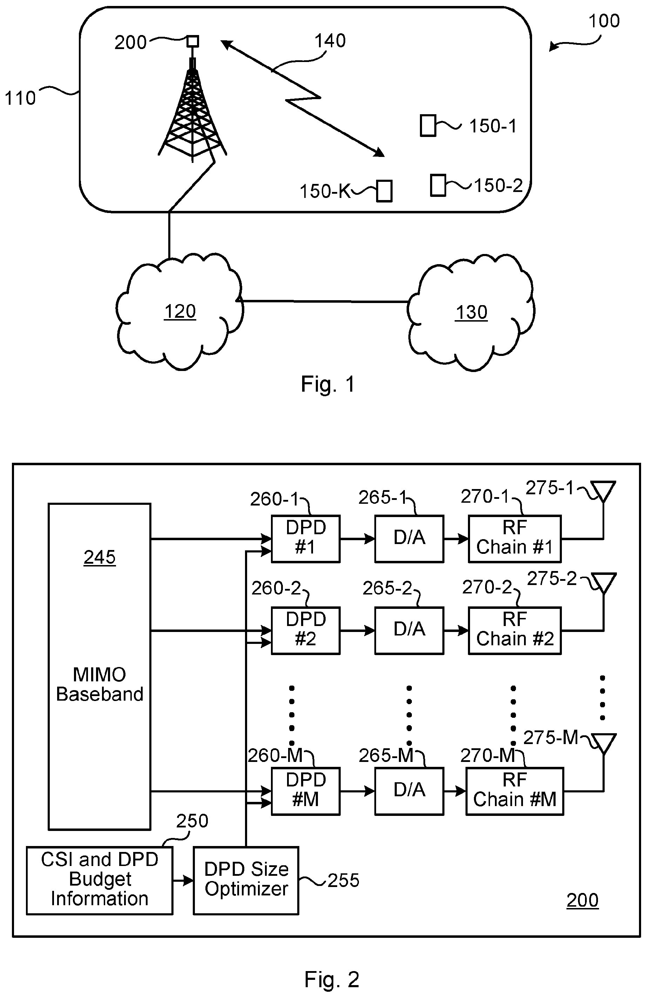

**Fig. 1** is a schematic diagram illustrating a communications network 100 where embodiments presented herein can be applied. The communications network 100 could be a third generation (3G) telecommunications network, a fourth generation (4G) telecommunications network, a fifth generation (5G) telecommunications network, or any evolvement thereof, and support any 3GPP telecommunications standard, where applicable. The communications network 100 could alternatively be a non-cellular and/or a non-3GPP network, such as an IEEE 802.11 communications network, or any other wireless IEEE compliant communications network. In some examples, the communications network 100 is a massive MIMO system.

The communications network 100 comprises an access node 200 configured to provide network access to user equipment, as represented by user equipment 150-1, 150-2, ..., 150-K, in a (radio) access network 110, over wireless links 140. The (radio) access network 110 is operatively connected to a core network 120. The core network 120 is in turn operatively connected to a service network 130, such as the Internet. The user equipment 150-1, 150-2, ..., 150-K are thereby enabled to, via the access node 200, access services of, and exchange data with, the service network 130.

Examples of access nodes 200 are radio access network nodes, radio base stations, base transceiver stations, Node Bs, evolved Node Bs, gNBs, access points, and integrated access and backhaul nodes. Examples of user equipment 150-1, 150-2, ..., 150-K are wireless devices, mobile stations, mobile phones, handsets, wireless local loop phones, smartphones, laptop computers, tablet computers, network equipped sensors, network equipped vehicles, and so-called Internet of Things devices.

As noted above, there is still a need for improved configuration of DPDs intended for operation in a massive MIMO system.

In this respect, using a per-antenna DPD at the access node 200 is known to be the practical choice for the massive MIMO systems. One issue with using a per-antenna DPD is that the per-antenna DPD sizes are selected uniformly, without taking the variation of the channel quality into account. Further, the power consumption of the DPD grows linearly with the DPD size, i.e., the total available number of coefficients used by the DPD. Dynamic model sizing algorithms have been introduced, see Y. Li and A. Zhu, "On-demand real-time optimizable dynamic model sizing for digital predistortion of broadband RF power amplifiers," IEEE Transactions on Microwave Theory and Techniques, vol. 68, no. 7, pp. 2891-2901, 2020. One aim of such dynamic model sizing algorithms is to change the DPD size of a transceiver when needed during the transmission and save the power. But the dynamic model sizing algorithms are limited to a single-input single-output (SISO) system and cannot be readily applied to a massive MIMO system where the DPD power consumption of all the antennas over the antenna array needs to be taken into account. With a difference in antennas contribution and limiting constraint on DPD power consumption, a new technique that improves the per-antenna DPD performance and the energy efficiency of the massive MIMO systems is therefore proposed and disclosed hereinafter.

The embodiments disclosed herein in particular relate to mechanisms for DPD size determination of the access node 200. In order to obtain such mechanisms there is provided an access node 200, a method performed by the access node 200, a computer program product comprising code, for example in the form of a computer program, that when run on an access node 200, causes the access node 200 to perform the method.

As noted above, in massive MIMO systems, the contribution of each antenna to the system capacity is not equal due to large-scale variations across the array of antennas. Only a portion of the antennas with strongest channels determines the system performance. Measurements in realistic environments with implemented massive MIMO systems have verified that even in wide-band multi-user scenarios, this property holds. In a fully digital massive MIMO system, there is one RF chain per antenna. This results in high power consumption in the analog front ends if all the RF chains have to meet the demanded linearity constraints. On the other hand, performing digital pre-distortion with the same number of coefficients in each DPD on all RF chains to mitigate non-linearity distortion, which is usually designed for the worst-case scenarios, also results in a large power consumption.

The downlink of a fully digital massive MIMO system where each antenna is connected to an RF chain (with non-ideal hardware components) is considered. **Fig. 2** is a schematic block diagram of an access node 200 according to an embodiment. The access node 200 comprises a plurality of antennas 275-1, 275-2, ..., 275-M. The access node 200 comprises one radio chain 270-1, 270-2, ..., 270-M per antenna 275-1, 275-2, ..., 275-M. The access node 200 comprises one DPD 260-1, 260-2, ..., 260-M per radio chain 270-1, 270-2, ..., 270-M.

The size of each DPD 260-1, 260-2, ..., 260-M can be adaptively selected based on current channel state information. This allows individual adaptation per DPD 260-1, 260-2, ..., 260-M of the level of pre-distortion based on current channel state information. The access node 200 further comprises one digital to analog (D/A) converter 265-1, 265-2, ..., 265-M per radio chain 270-1, 270-2, ..., 270-M. The antennas 275-1, 275-2, ..., 275-M are, via the radio chains 270-1, 270-2, ..., 270-M, the D/A converters 265-1, 265-2, ..., 265-M, and the DPDs 260-1, 260-2, ..., 260-M operatively connected to a MIMO baseband signalling block 245.

The power consumption of the DPDs 260-1, 260-2, ..., 260-M has a linear relationship with the number of coefficients used in the DPDs 260-1, 260-2, ..., 260-M. This allows the DPD power consumption $P_{DPD}$ to be related to the total number of DPD coefficients across all RF chains, and thus all transmit branches, as $P_{DPD} = C \cdot N_{coef}$, where $N_{coef}$ is the total number of DPD coefficients across all antennas 275-1, 275-2, ..., 275-M and C is a proportionality constant. However, this relation does not require that the total number of DPD coefficients are equally divided among the DPDs 260-1, 260-2, ..., 260-M. Hence, for a given value of $N_{coef}$ (or equally, for a given value of $P_{DPD}$) different number of coefficients could be allocated to the different DPDs 260-1, 260-2, ..., 260-M as long as the value of $N_{coef}$ (or equally, the value of $P_{DPD}$) is not changed. In this respect, the size of each DPD 260-1, 260-2, ..., 260-M is controlled by a DPD size optimizer block 255. The input to DPD size optimizer block 250 is the channel gain estimates, which could be acquired in the uplink by receiving pilot signals from the UEs 150-1, 150-2, ..., 150-K, and the DPD power budget (as given by $P_{DPD}$), which determines the total number of DPD coefficients that can be used across the antennas 275-1, 275-2, ..., 275-M (according to the above relation, $P_{DPD} = C \cdot N_{coef}$). The DPD size optimizer block 255 is therefore configured to receive input from a channel state information (CSI) and DPD budget information block 250. The DPD size optimizer block 255 is configured to optimize the per-antenna DPD sizes by exploiting CSI, in terms of the channel gain variation across the antennas 275-1, 275-2, ..., 275-M, to adapt the level of DPD compensation across the across the antennas 275-1, 275-2, ..., 275-M.

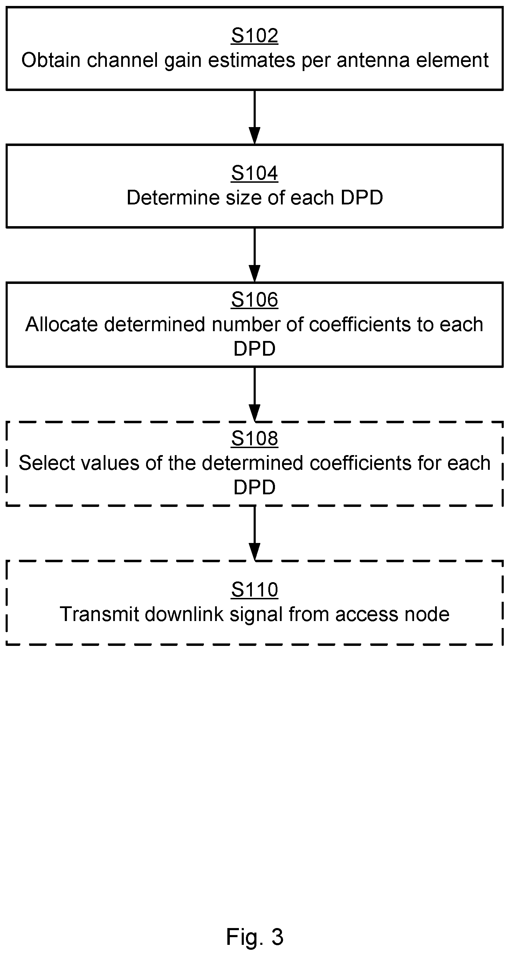

In brief, and as will be disclosed in more detail next with reference to Fig. 3, the access node 200 first obtains an estimate of the channel from each antenna 275-1, 275-2, ..., 275-M to the UEs 150-1, 150-2, ..., 150-K. In this respect, although channel gain estimates are disclosed below as estimates of the channel, the herein disclosed embodiments are equally applicable also to other types estimates of the channel, such as channel phase estimates, CSI (which can contain information reflecting both channel gain estimates and channel phase estimates as well as other channel parameters), etc. A utility function is then selected according to which the per-antenna optimization of the DPD size is performed. This utility function depends on the channel gain estimates. High mobility of the UEs 150-1, 150-2, 150-K might cause their channel conditions to change fast over time. Therefore, the utility function is selected to only depend on large-scale fading of the channel. The utility function might further depend on other parameters, such as hardware quality, and the total amount of available coefficients to be allocated to the DPD. The access node 200 can then determine the optimum values of the per-antenna DPD sizes to optimize the utility function for the given constraints and apply the results to the DPDs 260-1, 260-2, ..., 260-M before performing any transmission.

Fig. 3 is a flowchart illustrating embodiments of methods for DPD size determination of the access node 200. The methods are performed by the access node 200. The methods are advantageously provided as computer programs 820.

The method is based on having access to information of channel gain estimates per antenna 275-1, 275-2, ..., 275-M. Hence, the access node 200 is configured to perform step S102:

S102: The access node 200 obtains channel gain estimates per each of the plurality of antennas 275-1, 275-2, ..., 275-M.

Step 102 might be implemented in, or performed by, the CSI and DPD budget information block 255. The size of each of the DPDs 260-1, 260-2, ..., 260-M is then determined as a function of the channel gain estimates per antenna 275-1, 275-2, ..., 275-M, as in step S104:

S104: The access node 200 determines the size, in terms of number of coefficients, of each DPD 260-1, 260-2, ..., 260-M according to a utility function. The utility function depends on the channel gain estimates per antenna 275-1, 275-2, ..., 275-M.

Step 104 might be implemented in, or performed by, the DPD size optimizer block 255. Information about how many coefficients to use is then communicated to the DPDs 260-1, 260-2, ..., 260-M, as in step S106:

S106: The access node 200 allocates the determined number of coefficients to each DPD 260-1, 260-2, ..., 260-M.

Step 106 might be implemented in, or performed by, the DPD size optimizer block 255.

Enabling the DPD size, i.e. the number of coefficients per each DPD 260-1, 260-2, ..., 260-M, to be adapted can help the massive MIMO system to adapt to large-scale fluctuations in channel gains and signal power. The available DPD coefficients can be distributed across the antennas 275-1, 275-2, ..., 275-M based on their large-scale fading channel conditions, as indicated by the channel gain estimates per each of the plurality of antennas 275-1, 275-2, ..., 275-M, to ensure that the antennas 275-1, 275-2, ..., 275-M with more contribution to the system experience less hardware distortion.

Embodiments relating to further details of DPD size determination of the access node 200 as performed by the access node 200 will now be disclosed.

As disclosed above, the available DPD coefficients can be distributed across the antennas 275-1, 275-2, ..., 275-M based on their large-scale fading channel conditions. Particularly, in some embodiments, the channel gain estimates represent moving average channel conditions.

There may be different actions taken by the access node 200 once having allocated the determined number of coefficients to each DPD 260-1, 260-2, ..., 260-M, as in step S106.

In general terms, each of the coefficients has a value. However, it might be difficult to determine, assign, or select, the values of the coefficients for the DPDs 260-1, 260-2, ..., 260-M before it is known how many coefficients that will be allocated to each DPD 260-1, 260-2, ..., 260-M. Therefore, in some aspects, once the determined number of coefficients has been allocated to each DPD 260-1, 260-2, ..., 260-M, as in step S106, the actual values of the coefficients can be selected. Hence, in some embodiments, the access node 200 is configured to perform (optional) step S108:

S108: The access node 200 selects values of the coefficients as determined for each DPD 260-1, 260-2, ..., 260-M.

Step 108 might be implemented in, or performed by, the DPD size optimizer block 255. Alternatively, step S106 is implemented in, or performed by, each of the DPDs 260-1, 260-2, ..., 260-M, possibly in collaboration with the DPD size optimizer block 255.

Once the values of coefficients have been determined for each DPD 260-1, 260-2, ..., 260-M, the DPDs 260-1, 260-2, ..., 260-M can be used for pre-distorting a signal to be transmitted by the access node 200. Hence, in some embodiments, the access node 200 is configured to perform (optional) step S110:

S110: The access node 200 transmits a downlink signal from the access node 200. The downlink signal is pre-distorted by the DPDs 260-1, 260-2, ..., 260-M according to the selected values of the coefficients.

Step 110 might be implemented in, or performed by, the MIMO baseband signalling block 245.

Further aspects of how the DPD sizes might be determined will now be disclosed.

In some aspects, the DPD sizes are selected to maximize the utility function for given constraints. In particular, in some embodiments, the sizes of all the DPDs 260-1, 260-2, ..., 260-M are collectively determined to maximize the utility function. In some aspects, the utility function is constrained by the total number of available coefficients for all the DPDs 260-1, 260-2, ..., 260-M. That is, in some embodiments, the utility function is constrained by a maximum total number of coefficients collectively allocatable to all DPDs 260-1, 260-2, ..., 260-M. In some embodiments, the maximum total number of coefficients is dependent on a total available power budget for the DPDs 260-1, 260-2, ..., 260-M.

Further aspects of the utility function will now be disclosed.

As disclosed above, the utility function might further depend on other parameters, such as hardware quality. That is, in some embodiments, the utility function further depends on properties of hardware components per radio chain 270-1, 270-2, ..., 270-M. Some examples, of the hardware components are PAs and D/A converters 265-1, 265-2, ..., 265-M.

There could be different ways to select the utility function. In some embodiments, the utility function is derived from an optimization criterion. There could be different examples of such optimization criteria. In some non-limiting examples, the optimization criterion pertains to any of: maximization of downlink capacity of the access node 200, minimization of power consumption of the DPDs 260-1, 260-2, ..., 260-M for a given system performance of the access node 200, maximization of system performance of the access node 200 for a given power consumption of the DPDs 260-1, 260-2, ..., 260-M. That is, given an optimization criterion (such as minimal DPD power consumption for a given system performance or maximum system performance for a limited DPD power consumption) the individual DPD sizes can be optimized based on the current channel state information.

In some aspects, the utility function is an objective function. In other aspects, the utility function can be regarded as a reward function, a profit function, or, a fitness function.

One non-limiting way to implement the utility function for per-antenna DPD size determination will be disclosed next for completeness of this disclosure.

Consider that an access node 200 with $M$ antennas 275-1, 275-2, ..., 275-M is to, over a radio propagation channel represented by a channel vector $\boldsymbol{h}$, serve a UE 150-1 having a single-antenna in the presence of hardware impairment at both the access node 200 and the UE 150-1. The received baseband signal y at the UE 150-1 side can be expressed as:

$$y = \boldsymbol{h}^T\left(\boldsymbol{s} + \boldsymbol{d}^{\mathrm{AN}}\right) + d^{\mathrm{UE}} + \omega,$$

where s is the transmit signal at the access node 200 with a covariance matrix $\boldsymbol{W}$ such that $\mathrm{tr}(\boldsymbol{W}) = P_T$, where $\mathrm{tr}(\boldsymbol{W})$ is the trace of $\boldsymbol{W}$, where $P_T$ is the transmission power, where $\boldsymbol{d}^{\mathrm{AN}}$ and $d^{\mathrm{UE}}$ are the residual hardware impairment at the access node and UE side, respectively, and where $\omega \sim CN(o, \sigma^2)$ represents additive noise at the UE side. To quantify the dependency of the capacity on the per-antenna DPD sizes, the residual hardware impairment terms can be modelled as follows:

$$\boldsymbol{d}^{\mathrm{AN}} \sim CN\left(o, \boldsymbol{Q}^{\mathrm{AN}}\right),$$

where

$$Q^{\mathrm{AN}} = \kappa^{\mathrm{AN}} \mathrm{diag} \left\{ \frac{W_{11}}{n_1^{\mathrm{DPD}}}, \frac{W_{22}}{n_2^{\mathrm{DPD}}}, \dots, \frac{W_{MM}}{n_M^{\mathrm{DPD}}} \right\},$$

and

$$d^{\mathrm{UE}} \sim CN\left(o, q^{\mathrm{UE}}\right),$$

where

$$q^{\mathrm{UE}} = \kappa^{\mathrm{UE}}\left(h^T W h^*\right).$$

In the above expression, $\kappa^{\mathrm{AN}}$ is a measure of hardware impairment variance if no digital pre-distortion is applied, $W_{mm}$ is the m:th diagonal element in the matrix $W$, $n_m^{\mathrm{DPD}}$ is the DPD size allocated to the m:th antenna branch, and $\kappa^{\mathrm{UE}}$ is a measure of the hardware impairment variance at the UE side.

An upper bound $\tilde{C}^{\mathrm{UB}}$ on the capacity when the channel distribution is $h \sim CN(o, R)$ can be found as:

$$\tilde{C}^{\mathrm{UB}} = \log_2\left(1 + \frac{\tilde{G}^{\mathrm{DL}}}{1 + \kappa^{\mathrm{UE}}\tilde{G}^{\mathrm{DL}}}\right),$$

where

$$\tilde{G}^{\mathrm{DL}} = \frac{1}{\kappa^{\mathrm{AN}}} \sum_{m=1}^{M} n_m^{\mathrm{DPD}} \left[1 - \frac{1}{2}\tau_m \ln\left(1 + \frac{2}{\tau_m}\right)\right],$$

where

$$\tau_m = \frac{\sigma^2 n_m^{\mathrm{DPD}}}{\kappa^{\mathrm{AN}} P_T R_{mm}}.$$

The capacity upper bound $\tilde{C}^{\mathrm{UB}}$ is thus a function of the large-scale fading components of the channel and the DPD sizes at each antenna 275-1, 275-2, ..., 275-M. Therefore, this capacity can be selected as the optimization criterion for the utility function. For given channel state information and a constraint on the total number of the per-antenna DPD coefficients, the below optimization problem can thus be solved to find the optimal per-antenna DPD sizes $n_m^{\mathrm{DPD}}$:

$$\max_{n_m^{\mathrm{DPD}}} \frac{1}{\kappa^{\mathrm{AN}}} \sum_{m=1}^{M} n_m^{\mathrm{DPD}} \left[1 - \frac{1}{2}\tau_m \ln\left(1 + \frac{2}{\tau_m}\right)\right]$$

subject to:

$$n_m^{\mathrm{DPD}} \geq 1, \qquad m = 1, 2, \dots, M$$

$$\sum_{m=1}^{M} n_m^{\mathrm{DPD}} = n_{\mathrm{max}}^{\mathrm{DPD}}$$

$$n_m^{\mathrm{DPD}} \in \mathbb{N}, \qquad m = 1, 2, \dots, M.$$

Thus far it has been assumed that the total number of DPD coefficients that can be used across the antennas 275-1, 275-2, ..., 275-M has a fixed value $N_{\mathrm{coef}}$. However, as the DPD power consumption $P_{\mathrm{DPD}}$ might be varying over time, this also allows the total number of DPD coefficients that can be used across the antennas 275-1, 275-2, ..., 275-M to vary over time. Hence, in some embodiments, the maximum total number of coefficients varies over time. In this respect, the DPD sizes can be updated in real-time using a dynamic DPD model that adapts the DPD sizes from previous time. In particular, in some embodiments, the sizes of the DPDs 260-1, 260-2, ..., 260-M are, according to a dynamic model, adaptively determined over time based on previously determined sizes of the DPDs 260-1, 260-2, ..., 260-M. As illustrated in the above example, this is possible with a low complexity optimization problem to be solved at the access node 200. Real-time dynamic DPD sizing methods that can converge very fast when the DPD size change over time can be applied.

In some aspects, in multi-user scenario the utility function can be made dependent on the downlink capacity of each served user equipment 150-1, 150-2, 150-K. In particular, in some embodiments, the access node 200 in step S102 obtains channel gain estimates per each of the plurality of antennas 275-1, 275-2, ..., 275-M for a plurality of user equipment 150-1, 150-2, 150-K served by the access node 200, and the utility function depends on downlink capacity for each of the user equipment 150-1, 150-2, 150-K. In further detail, the above analysis can be implemented for an optimization problem for a multi-user scenario. This can be done by finding the downlink capacity of each user equipment 150-1, 150-2, 150-K after applying the per-antenna DPDs with the same model described in the above example, selecting a function of the capacities, e.g. summation or the minimum of them, and solving the optimization problem to find the optimum per-antenna DPD sizes.

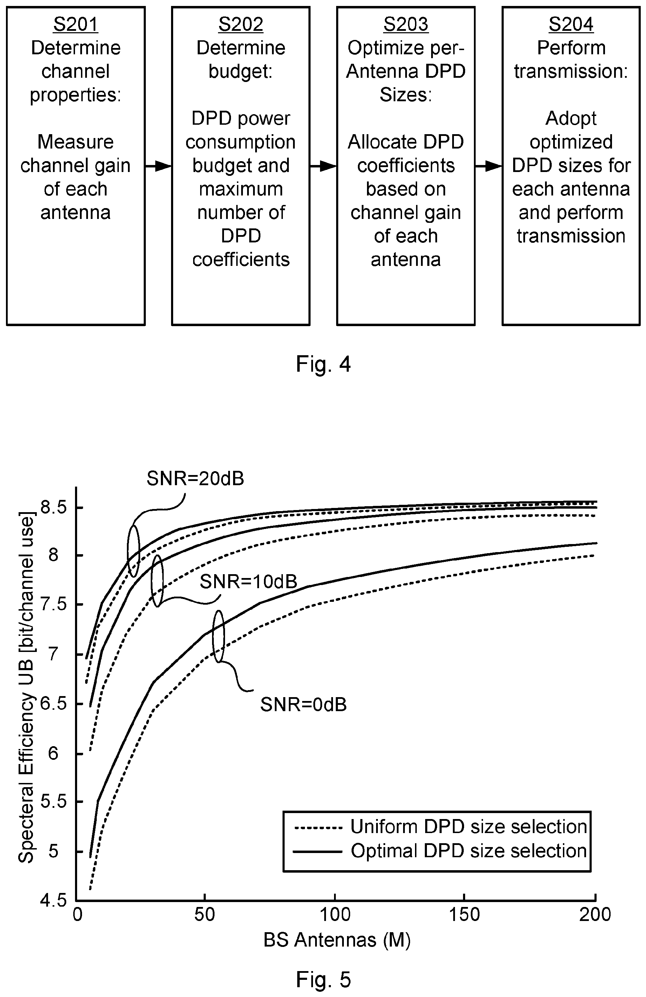

One particular embodiment of a method for DPD size determination of the access node 200 based on at least some of the above embodiments, aspects, and examples, will now be disclosed with reference to the flowchart of **Fig. 4.**

S201. Determining Channel Properties: The access node 200 obtains channel gain estimates per each of the plurality of antennas 275-1, 275-2, ..., 275-M from each antenna 275-1, 275-2, ..., 275-M to the UEs 150-1, 150-2, 150-K. The access node 200 stores the obtained channel gain estimates in a buffer. The needed data for performing the estimation can be achieved from measurements in the uplink on pilot signals transmitted by the UEs 150-1, 150-2, 150-K to the access node 200.

S202. Determining Budget: The access node 200 determines the total available power budget that can be used in all the DPDs 260-1, 260-2, ..., 260-M. As the DPD power consumption grows linearly with the DPD size (i.e., the number of coefficients per DPD), this power budget can be translated into the total number of available DPD coefficients across all antennas 275-1, 275-2, ..., 275-M that can be allocated to the DPDs 260-1, 260-2, ..., 260-M.

S203. Optimizing Per-Antenna DPD Sizes: The access node 200 selects a utility function according to which the DPD sizes are to be optimized. The selected utility function can be different depending on the application and other network design criteria, but has a dependency on channel characteristics (as defined by the channel gain estimates) and, possibly, the per-antenna DPD sizes (number of coefficients). One such option for the utility function is to consider the downlink capacity. After selecting the utility function, the access node 200 determines the size of each DPD 260-1, 260-2, ..., 260-M according to the utility function and the DPD power budget constraints.

S204. Performing Transmission: The access node 200 allocates the determined number of coefficients to each DPD 260-1, 260-2, ..., 260-M. The access node 200 also selects values of the coefficients as determined for each DPD 260-1, 260-2, ..., 260-M. Further, the access node 200 transmit a downlink signal. The downlink signal is pre-distorted by the DPDs 260-1, 260-2, ..., 260-M according to the selected values of the coefficients.

Next it will with reference to Fig. 5 be shown how the herein disclosed embodiments can be used in a massive MIMO system to achieve the above-mentioned advantages. Fig. 5 shows simulation results in terms of a numerical example of the system performance for the proposed method for per-antenna DPD size selection. In particular, in **Fig. 5** is shown the achievable gain of adopting the proposed method in comparison to the case of uniform DPD size selection in terms of spectral efficiency upper bound (UB) as a function of number of antennas at the access node 200. To take into account the varying channel gain over the antennas 275-1, 275-2, ..., 275-M, it is assumed that 20% of the antennas experience a gain which is 10dB higher than the rest of the antennas. A Rayleigh fading model is used to generate the channel realizations and the average DPD size per antenna is set to 20.

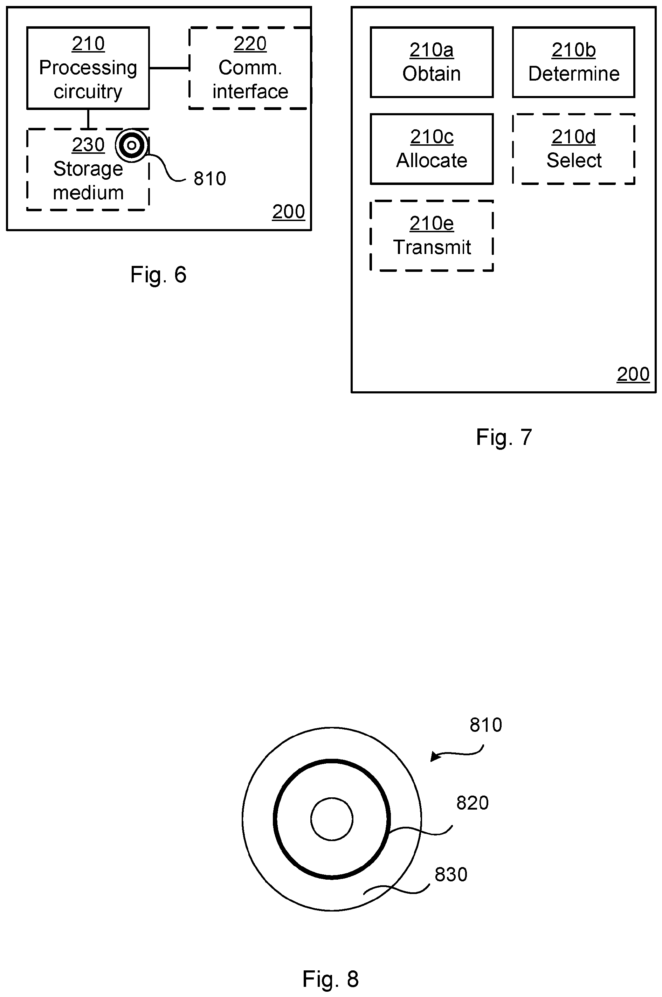

**Fig. 6** schematically illustrates, in terms of a number of functional units, the components of an access node 200 according to an embodiment. Processing circuitry 210 is provided using any combination of one or more of a suitable central processing unit (CPU), multiprocessor, microcontroller, digital signal processor (DSP), etc., capable of executing software instructions stored in a computer program product 810 (as in Fig. 8), e.g. in the form of a storage medium 230. The processing circuitry 210 may further be provided as at least one application specific integrated circuit (ASIC), or field programmable gate array (FPGA).

Particularly, the processing circuitry 210 is configured to cause the access node 200 to perform a set of operations, or steps, as disclosed above. For example, the storage medium 230 may store the set of operations, and the processing circuitry 210 may be configured to retrieve the set of operations from the storage medium 230 to cause the access node 200 to perform the set of operations. The set of operations may be provided as a set of executable instructions.

Thus the processing circuitry 210 is thereby arranged to execute methods as herein disclosed. The storage medium 230 may also comprise persistent storage, which, for example, can be any single one or combination of magnetic memory, optical memory, solid state memory or even remotely mounted memory. The access node 200 may further comprise a communications interface 220 at least configured for communications with other entities, functions, nodes, and devices of the communications network 100 as well as entities, functions, nodes, and devices served by the communications network 100. As such the communications interface 220 may comprise one or more transmitters and receivers, comprising analogue and digital components. The processing circuitry 210 controls the general operation of the access node 200 e.g. by sending data and control signals to the communications interface 220 and the storage medium 230, by receiving data and reports from the communications interface 220, and by retrieving data and instructions from the storage medium 230. Other components, as well as the related functionality, of the access node 200 are omitted in order not to obscure the concepts presented herein.

**Fig. 7** schematically illustrates, in terms of a number of functional modules, the components of an access node 200 according to an embodiment. The access node 200 of Fig. 7 comprises a number of functional modules; an obtain module 210a configured to perform step S102, a determine module 210b configured to perform step S106, and an allocate module 210c configured to perform step S106. The access node 200 of Fig. 7 may further comprise a number of optional functional modules, such as any of a select module 210d configured to perform step S 108 and a transmit module 210e configured to perform step S210. **In** general terms, each functional module 210a:210e may in one embodiment be implemented only in hardware and in another embodiment with the help of software, i.e., the latter embodiment having computer program instructions stored on the storage medium 230 which when run on the processing circuitry makes the access node 200 perform the corresponding steps mentioned above in conjunction with Fig 7. It should also be mentioned that even though the modules correspond to parts of a computer program, they do not need to be separate modules therein, but the way in which they are implemented in software is dependent on the programming language used. Preferably, one or more or all functional modules 210a:210e may be implemented by the processing circuitry 210, possibly in cooperation with the communications interface 220 and/or the storage medium 230. The processing circuitry 210 may thus be configured to from the storage medium 230 fetch instructions as provided by a functional module 210a:210e and to execute these instructions, thereby performing any steps as disclosed herein.

The access node 200 may be provided as a standalone device or as a part of at least one further device. For example, the access node 200 may be provided in a node of the radio access network or in a node of the core network. Alternatively, functionality of the access node 200 may be distributed between at least two devices, or nodes. These at least two nodes, or devices, may either be part of the same network part (such as the radio access network or the core network) or may be spread between at least two such network parts. In general terms, instructions that are required to be performed in real time may be performed in a device, or node, operatively closer to the cell than instructions that are not required to be performed in real time. Thus, a first portion of the instructions performed by the access node 200 may be executed in a first device, and a second portion of the of the instructions performed by the access node 200 may be executed in a second device; the herein disclosed embodiments are not limited to any particular number of devices on which the instructions performed by the access node 200 may be executed. Hence, the methods according to the herein disclosed embodiments are suitable to be performed by an access node 200 residing in a cloud computational environment. Therefore, although a single processing circuitry 210 is illustrated in Fig. 6 the processing circuitry 210 may be distributed among a plurality of devices, or nodes. The same applies to the functional modules 210a:210e of Fig. 7 and the computer program 820 of Fig. 8.

**Fig. 8** shows one example of a computer program product 810 comprising computer readable storage medium 830. On this computer readable storage medium 830, a computer program 820 can be stored, which computer program 820 can cause the processing circuitry 210 and thereto operatively coupled entities and devices, such as the communications interface 220 and the storage medium 230, to execute methods according to embodiments described herein. The computer program 820 and/or computer program product 810 may thus provide means for performing any steps as herein disclosed.

In the example of Fig. 8, the computer program product 810 is illustrated as an optical disc, such as a CD (compact disc) or a DVD (digital versatile disc) or a Blu-Ray disc. The computer program product 810 could also be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory. Thus, while the computer program 820 is here schematically shown as a track on the depicted optical disk, the computer program 820 can be stored in any way which is suitable for the computer program product 810.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

**Claims**

1. An access node (200) for digital pre-distorter, DPD, size determination of the access node (200), the access node (200) being configured for operation in a digital massive multiple-input multiple-output, MIMO, system (100), the access node (200) comprising a plurality of antennas (275-1, 275-2, ..., 275-M), one radio chain (270-1, 270-2, ..., 270-M) per antenna (275-1, 275-2, ..., 275-M), and one DPD (260-1, 260-2, ..., 260-M) per radio chain (270-1, 270-2, ..., 270-M), the access node (200) comprising processing circuitry (210), the processing circuitry (210) being configured to cause the access node (200) to:

   obtain channel gain estimates per each of the plurality of antennas (275-1, 275-2, ..., 275-M);
   determine the size, in terms of number of coefficients, of each DPD (260-1, 260-2, ..., 260-M) according to a utility function that depends on the channel gain estimates per antenna (275-1, 275-2, ..., 275-M); and
   allocate the determined number of coefficients to each DPD (260-1, 260-2, ..., 260-M).

2. The access node (200) according to claim 1, the processing circuitry (210) further being configured to cause the access node (200) to:

   select values of the coefficients as determined for each DPD (260-1, 260-2, ..., 260-M) and transmit a downlink signal from the access node (200), wherein the downlink signal is pre-distorted by the DPDs (260-1, 260-2, ..., 260-M) according to the selected values of the coefficients.

3. The access node (200) according any preceding claim, wherein the channel gain estimates represent moving average channel conditions.

4. The access node (200) according to any preceding claim, wherein the sizes of all the DPDs (260-1, 260-2, ..., 260-M) are collectively determined to maximize the utility function.

5. The access node (200) according to any preceding claim, wherein the utility function is constrained by a maximum total number of coefficients collectively allocatable to all DPDs (260-1, 260-2, ..., 260-M), wherein the maximum total number of coefficients is dependent on a total available power budget for the DPDs (260-1, 260-2, ..., 260-M) or wherein the maximum total number of coefficients varies over time and/or

   wherein the utility function further depends on properties of hardware components per radio chain (270-1, 270-2, ..., 270-M) and/or
   wherein the utility function is derived from an optimization criterion, and wherein the optimization criterion pertains to any of: maximization of downlink capacity of the access node (200), minimization of power consumption of the DPDs (260-1, 260-2, ..., 260-M) for a given system performance of the access node (200), maximization of system performance of the access node (200) for a given power consumption of the DPDs (260-1, 260-2, ..., 260-M).

6. The access node (200) according to any preceding claim, wherein the sizes of the DPDs (260-1, 260-2, ..., 260-M) are, according to a dynamic model, adaptively determined over time based on previously determined sizes of the DPDs (260-1, 260-2, ..., 260-M).

7. The access node (200) according to any preceding claim, wherein the access node (200) obtains channel gain estimates per each of the plurality of antennas (275-1, 275-2, ..., 275-M) for a plurality of user equipment (150-1, 150-2, 150-K) served by the access node (200), and wherein the utility function depends on downlink capacity for each of the user equipment (150-1, 150-2, 150-K).

8. A method for digital pre-distorter, DPD, size determination of an access node (200), the access node (200) being configured for operation in a digital massive multiple-input multiple-output, MIMO, system (100), the access node (200) comprising a plurality of antennas (275-1, 275-2, ..., 275-M), one radio chain (270-1, 270-2, ..., 270-M) per antenna (275-1, 275-2, ..., 275-M), and one DPD (260-1, 260-2, ..., 260-M) per radio chain (270-1, 270-2, ..., 270-M), the method being performed by the access node (200), the method comprising:

   obtaining (S102) channel gain estimates per each of the plurality of antennas (275-1, 275-2, ..., 275-M);
   determining (S104) the size, in terms of number of coefficients, of each DPD (260-1, 260-2, ..., 260-M) according to a utility function that depends on the channel gain estimates per antenna (275-1, 275-2, ..., 275-M); and
   allocating (S106) the determined number of coefficients to each DPD (260-1, 260-2, ..., 260-M).

9. The method according to claim 8, wherein the method further comprises:

   selecting (S108) values of the coefficients as determined for each DPD (260-1, 260-2, ..., 260-M) and
   transmitting (S110) a downlink signal from the access node (200), wherein the downlink signal is pre-distorted by the DPDs (260-1, 260-2, ..., 260-M) according to the selected values of the coefficients.

10. The method according to any of claims 8 to 9, wherein the channel gain estimates represent moving average channel conditions.

11. The method according to any of claims 8 to 10, wherein the sizes of all the DPDs (260-1, 260-2, ..., 260-M) are collectively determined to maximize the utility function and/or wherein the sizes of the DPDs (260-1, 260-2, ..., 260-M) are, according to a dynamic model, adaptively determined over time based on previously determined sizes of the DPDs (260-1, 260-2, ..., 260-M).

12. The method according to any of claims 8 to 11, wherein the utility function is constrained by a maximum total number of coefficients collectively allocatable to all DPDs (260-1, 260-2, ..., 260-M), wherein the maximum total number of coefficients is dependent on a total available power budget for the DPDs (260-1, 260-2, ..., 260-M) or wherein the maximum total number of coefficients varies over time and/or

   wherein the utility function further depends on properties of hardware components per radio chain (270-1, 270-2, ..., 270-M) and/or
   wherein the utility function is derived from an optimization criterion, and wherein the optimization criterion pertains to any of: maximization of downlink capacity of the access node (200), minimization of power consumption of the DPDs (260-1, 260-2, ..., 260-M) for a given system performance of the access node (200), maximization of system performance of the access node (200) for a given power consumption of the DPDs (260-1, 260-2, ..., 260-M).

13. The method according to any of claims 8 to 12, wherein the access node (200) obtains channel gain estimates per each of the plurality of antennas (275-1, 275-2, ..., 275-M) for a plurality of user equipment (150-1, 150-2, 150-K) served by the access node (200), and wherein the utility function depends on downlink capacity for each of the user equipment (150-1, 150-2, 150-K).

14. A computer program (820) for digital pre-distorter, DPD, size determination of an access node (200), the access node (200) being configured for operation in a digital massive multiple-input multiple-output, MIMO, system (100), the access node (200) comprising a plurality of antennas (275-1, 275-2, ..., 275-M), one radio chain (270-1, 270-2, ..., 270-M) per antenna (275-1, 275-2, ..., 275-M), and one DPD (260-1, 260-2, ..., 260-M) per radio chain (270-1, 270-2, ..., 270-M), the computer program comprising computer code which, when run on processing circuitry (210) of the access node (200), causes the access node (200) to:

  obtain (S102) channel gain estimates per each of the plurality of antennas (275-1, 275-2, ..., 275-M);
  determine (S104) the size, in terms of number of coefficients, of each DPD (260-1, 260-2, ..., 260-M) according to a utility function that depends on the channel gain estimates per antenna (275-1, 275-2, ..., 275-M); and
  allocate (S106) the determined number of coefficients to each DPD (260-1, 260-2, ..., 260-M).

15. A computer program product (810) comprising a computer program (820) according to claim 14, and a computer readable storage medium (830) on which the computer program is stored.

**Patentansprüche**

1. Zugangsknoten (200) zur Bestimmung der Größe eines digitalen Vorverzerrers, DPD, des Zugangsknotens (200), wobei der Zugangsknoten (200) für Betrieb in einem digitalen massiven Mehrfacheingangs-Mehrfachausgangs-System, MIMO-System, (100) ausgelegt ist, der Zugangsknoten (200) eine Mehrzahl von Antennen (275-1, 275-2, ..., 275-M), eine Funkkette (270-1, 270-2, ..., 270-M) pro Antenne (275-1, 275-2, ..., 275-M) und einen DPD (260-1, 260-2, ..., 260-M) pro Funkkette (270-1, 270-2, ..., 270-M) umfasst, wobei der Zugangsknoten (200) Verarbeitungsschaltungsanordnung (210) umfasst, und die Verarbeitungsschaltungsanordnung (210) so ausgelegt ist, dass sie den Zugangsknoten (200) zu Folgendem veranlasst:

  Erhalten von Kanalgewinnschätzungen für jede der Mehrzahl von Antennen (275-1, 275-2, ..., 275-M);
  Bestimmen der Größe jedes DPD (260-1, 260-2, ..., 260-M) in Bezug auf eine Anzahl von Koeffizienten gemäß einer Nutzenfunktion, die von den Kanalgewinnschätzung pro Antenne (275-1, 275-2, ..., 275-M) abhängt; und
  Zuweisen der bestimmten Anzahl von Koeffizienten zu jedem DPD (260-1, 260-2, ..., 260-M).

2. Zugangsknoten (200) nach Anspruch 1, wobei die Verarbeitungsschaltungsanordnung (210) ferner so ausgelegt ist, dass sie den Zugangsknoten (200) zu Folgendem veranlasst:

  Auswählen von Werten der Koeffizienten, wie für jeden DPD (260-1, 260-2, ..., 260-M) bestimmt, und
  Senden eines Downlink-Signals von dem Zugangsknoten (200), wobei das Downlink-Signal durch die DPDs (260-1, 260-2, ..., 260-M) gemäß den ausgewählten Werten der Koeffizienten vorverzerrt wird.

3. Zugangsknoten (200) nach einem der vorhergehenden Ansprüche, wobei die Kanalgewinnschätzungen Kanalbedingungen im gleitenden Durchschnitt darstellen.

4. Zugangsknoten (200) nach einem der vorhergehenden Ansprüche, wobei die Größen aller DPDs (260-1, 260-2, ..., 260-M) gemeinsam bestimmt werden, um die Nutzenfunktion zu maximieren.

5. Zugangsknoten (200) nach einem der vorhergehenden Ansprüche, wobei die Nutzenfunktion durch eine maximale Gesamtanzahl von Koeffizienten beschränkt ist, die allen DPDs (260-1, 260-2, ..., 260-M) gemeinsam zugewiesen werden kann, wobei die maximale Gesamtanzahl von Koeffizienten von einem insgesamt verfügbaren Leistungsbudget für die DPDs (260-1, 260-2, ..., 260-M) abhängt oder wobei die maximale Gesamtanzahl von Koeffizienten im Lauf der Zeit variiert und/oder

  wobei die Nutzenfunktion ferner von Eigenschaften von Hardwarekomponenten pro Funkkette (270-1, 270-2, ..., 270-M) abhängt und/oder
  wobei die Nutzenfunktion von einem Optimierungskriterium abgeleitet wird und wobei das Optimierungskriterium eines von Folgendem betrifft: Maximierung der Downlink-Kapazität des Zugangsknotens (200), Minimierung des Leistungsverbrauchs der DPDs (260-1, 260-2, ..., 260-M) für eine gegebene Systemperformance des Zugangsknotens (200), Maximierung der Systemperformance des Zugangsknotens (200) für einen gegebenen Leistungsverbrauch der DPDs (260-1, 260-2, ..., 260-M).

6. Zugangsknoten (200) nach einem der vorhergehenden Ansprüche, wobei die Größen der DPDs (260-1, 260-2, ..., 260-M) gemäß einem dynamischen Modell im Lauf der Zeit basierend auf vorher bestimmen Größen der DPDs (260-1, 260-2, ..., 260-M) adaptiv bestimmt werden.

7. Zugangsknoten (200) nach einem der vorhergehenden Ansprüche, wobei der Zugangsknoten (200) Kanalgewinnschätzungen für jede der Mehrzahl von Antennen (275-1, 275-2, ..., 275-M) für eine Mehrzahl von Benutzereinrichtungen (150-1, 150-2, 150-K) erhält, die von dem Zugangsknoten (200) bedient werden, und wobei die Nutzenfunktion von einer Downlink-Kapazität für jede der Benutzereinrichtungen (150-1, 150-2, 150-K) abhängt.

8. Verfahren zur Bestimmung der Größe eines digitalen Vorverzerrers, DPD, eines Zugangsknotens (200), wobei der Zugangsknoten (200) für Betrieb in einem digitalen massiven Mehrfacheingangs-Mehrfachausgangs-System, MIMO-System, (100) ausgelegt ist, der Zugangsknoten (200) eine Mehrzahl von Antennen (275-1, 275-2, ..., 275-M), eine Funkkette (270-1, 270-2, ..., 270-M) pro Antenne (275-1, 275-2, ..., 275-M) und einen DPD (260-1, 260-2, ..., 260-M) pro Funkkette (270-1, 270-2, ..., 270-M) umfasst, wobei das Verfahren von dem Zugangsknoten (200) durchgeführt wird, und das Verfahren Folgendes umfasst:

Erhalten (S102) von Kanalgewinnschätzungen für jede der Mehrzahl von Antennen (275-1, 275-2, ..., 275-M); Bestimmen (S104) der Größe jedes DPD (260-1, 260-2, ..., 260-M) in Bezug auf eine Anzahl von Koeffizienten gemäß einer Nutzenfunktion, die von den Kanalgewinnschätzung pro Antenne (275-1, 275-2, ..., 275-M) abhängt; und Zuweisen (S106) der bestimmten Anzahl von Koeffizienten zu jedem DPD (260-1, 260-2, ..., 260-M).

9. Verfahren nach Anspruch 8, wobei das Verfahren ferner Folgendes umfasst:

Auswählen (S108) von Werten der Koeffizienten, wie für jeden DPD (260-1, 260-2, ..., 260-M) bestimmt, und Senden (S110) eines Downlink-Signals von dem Zugangsknoten (200), wobei das Downlink-Signal durch die DPDs (260-1, 260-2, ..., 260-M) gemäß den ausgewählten Werten der Koeffizienten vorverzerrt wird.

10. Verfahren nach einem der Ansprüche 8 bis 9, wobei die Kanalgewinnschätzungen Kanalbedingungen im gleitenden Durchschnitt darstellen.

11. Verfahren nach einem der Ansprüche 8 bis 10, wobei die Größen aller DPDs (260-1, 260-2, ..., 260-M) gemeinsam bestimmt werden, um die Nutzenfunktion zu maximieren und/oder wobei die Größen der DPDs (260-1, 260-2, ..., 260-M) gemäß einem dynamischen Modell im Lauf der Zeit basierend auf vorher bestimmen Größen der DPDs (260-1, 260-2, ..., 260-M) adaptiv bestimmt werden.

12. Verfahren nach einem der Ansprüche 8 bis 11, wobei die Nutzenfunktion durch eine maximale Gesamtanzahl von Koeffizienten beschränkt ist, die allen DPDs (260-1, 260-2, ..., 260-M) gemeinsam zugewiesen werden kann, wobei die maximale Gesamtanzahl von Koeffizienten von einem insgesamt verfügbaren Leistungsbudget für die DPDs (260-1, 260-2, ..., 260-M) abhängt oder wobei die maximale Gesamtanzahl von Koeffizienten im Lauf der Zeit variiert und/oder

wobei die Nutzenfunktion ferner von Eigenschaften von Hardwarekomponenten pro Funkkette (270-1, 270-2, ..., 270-M) abhängt und/oder wobei die Nutzenfunktion von einem Optimierungskriterium abgeleitet wird und wobei das Optimierungskriterium eines von Folgenden betrifft: Maximierung der Downlink-Kapazität des Zugangsknotens (200), Minimierung des Leistungsverbrauchs der DPDs (260-1, 260-2, ..., 260-M) für eine gegebene Systemperformance des Zugangsknotens (200), Maximierung der Systemperformance des Zugangsknotens (200) für einen gegebenen Leistungsverbrauch der DPDs (260-1, 260-2, ..., 260-M).

13. Verfahren nach einem der Ansprüche 8 bis 12, wobei der Zugangsknoten (200) Kanalgewinnschätzungen für jede der Mehrzahl von Antennen (275-1, 275-2, ..., 275-M) für eine Mehrzahl von Benutzereinrichtungen (150-1, 150-2, 150-K) erhält, die von dem Zugangsknoten (200) bedient werden, und wobei die Nutzenfunktion von einer Downlink-Kapazität für jede der Benutzereinrichtungen (150-1, 150-2, 150-K) abhängt.

14. Computerprogramm (820) zur Bestimmung der Größe eines digitalen Vorverzerrers, DPD, eines Zugangsknotens (200), wobei der Zugangsknoten (200) für Betrieb in einem digitalen massiven Mehrfacheingangs-Mehrfachausgangs-System, MIMO-System, (100) ausgelegt ist, der Zugangsknoten (200) eine Mehrzahl von Antennen (275-1, 275-2, ..., 275-M), eine Funkkette (270-1, 270-2, ..., 270-M) pro Antenne (275-1, 275-2, ..., 275-M) und einen DPD (260-1, 260-2, ..., 260-M) pro Funkkette (270-1, 270-2, ..., 270-M) umfasst, wobei das Computerprogramm Computercode umfasst, der bei Ausführung auf einer Verarbeitungsschaltungsanordnung (210) des Zugangsknotens (200) den Zugangsknoten (200) zu Folgendem veranlasst:

> Erhalten (S102) von Kanalgewinnschätzungen für jede der Mehrzahl von Antennen (275-1, 275-2, ..., 275-M);
> Bestimmen (S104) der Größe jedes DPD (260-1, 260-2, ..., 260-M) in Bezug auf eine Anzahl von Koeffizienten gemäß einer Nutzenfunktion, die von den Kanalgewinnschätzung pro Antenne (275-1, 275-2, ..., 275-M) abhängt; und
> Zuweisen (S106) der bestimmten Anzahl von Koeffizienten zu jedem DPD (260-1, 260-2, ..., 260-M).

15. Computerprogrammprodukt (810), umfassend ein Computerprogramm (820) nach Anspruch 14 und ein computerlesbares Speichermedium (830), auf dem das Computerprogramm gespeichert ist.

**Revendications**

1. Nœud d'accès (200) pour une détermination de taille de dispositif de prédistorsion numérique, DPD, du nœud d'accès (200), le nœud d'accès (200) étant configuré pour fonctionner dans un système à entrées multiples et sorties multiples, MIMO, massif numérique (100), le nœud d'accès (200) comprenant une pluralité d'antennes (275-1, 275-2, ..., 275-M), une chaîne radio (270-1, 270-2, ..., 270-M) par antenne (275-1, 275-2, ..., 275-M) et un DPD (260-1, 260-2, ..., 260-M) par chaîne radio (270-1, 270-2, ..., 270-M), le nœud d'accès (200) comprenant une circuiterie de traitement (210), la circuiterie de traitement (210) étant configurée pour amener le nœud d'accès (200) à :

> obtenir des estimations de gain de canal par antenne parmi la pluralité d'antennes (275-1, 275-2, ..., 275-M) ;
> déterminer la taille, en termes de nombre de coefficients, de chaque DPD (260-1, 260-2, ..., 260-M) selon une fonction d'utilité qui dépend des estimations de gain de canal par antenne (275-1, 275-2, ..., 275-M) ; et

> allouer le nombre déterminé de coefficients à chaque DPD (260-1, 260-2, ..., 260-M).

2. Nœud d'accès (200) selon la revendication 1, la circuiterie de traitement (210) étant en outre configurée pour amener le nœud d'accès (200) à :

> sélectionner des valeurs des coefficients telles que déterminées pour chaque DPD (260-1, 260-2, ..., 260-M) ; et
> transmettre un signal de liaison descendante depuis le nœud d'accès (200), dans lequel le signal de liaison descendante a subi une prédistorsion par les DPD (260-1, 260-2, ..., 260-M) selon les valeurs sélectionnées des coefficients.

3. Nœud d'accès (200) selon l'une quelconque des revendications précédentes, dans lequel les estimations de gain de canal représentent des conditions de canal de moyenne mobile.

4. Nœud d'accès (200) selon l'une quelconque des revendications précédentes, dans lequel les tailles de tous les DPD (260-1, 260-2, ..., 260-M) sont déterminées collectivement pour maximiser la fonction d'utilité.

5. Nœud d'accès (200) selon l'une quelconque des revendications précédentes, dans lequel la fonction d'utilité est limitée par un nombre total maximal de coefficients pouvant être alloués collectivement à tous les DPD (260-1, 260-2, ..., 260-M), dans lequel le nombre total maximal de coefficients dépend d'un budget de puissance disponible totale pour les DPD (260-1, 260-2, ..., 260-M) ou dans lequel le nombre total maximal de coefficients varie dans le temps, et/ou

> dans lequel la fonction d'utilité dépend en outre de propriétés de composants matériels par chaîne radio (270-1, 270-2, ..., 270-M), et/ou dans lequel la fonction d'utilité est dérivée d'un critère d'optimisation, et dans lequel le critère d'optimisation concerne l'une quelconque parmi : une maximisation d'une capacité de liaison descendante du nœud d'accès (200), une minimisation d'une consommation de puissance des DPD (260-1, 260-2, ..., 260-M) pour une performance de système donnée du nœud d'accès (200), une maximisation d'une performance de système du nœud d'accès (200) pour une consommation de puissance donnée des DPD (260-1, 260-2, ..., 260-M).

6. Nœud d'accès (200) selon l'une quelconque des revendications précédentes, dans lequel les tailles des DPD (260-1, 260-2, ..., 260-M) sont, selon un modèle dynamique, déterminées de manière adaptative dans le temps sur la base de tailles précédemment déterminées des DPD (260-1, 260-2, ..., 260-M).

7. Nœud d'accès (200) selon l'une quelconque des revendications précédentes, dans lequel le nœud d'accès (200) obtient des estimations de gain de canal par antenne parmi la pluralité d'antennes (275-1, 275-2, ..., 275-M) pour une pluralité d'équipements utilisateurs (150-1, 150-2, 150-K) desservis par le nœud d'accès (200), et dans lequel la fonction d'utilité dépend d'une capacité de liaison descendante pour chacun des équipements utilisateurs (150-1, 150-2, 150-K).

8. Procédé pour une détermination de taille de dispositif de prédistorsion numérique, DPD, d'un nœud d'accès (200), le nœud d'accès (200) étant configuré pour fonctionner dans un système à entrées multiples et sorties multiples, MIMO, massif numérique (100), le nœud d'accès (200) comprenant une pluralité d'antennes (275-1, 275-2, ..., 275-M), une chaîne radio (270-1, 270-2, ..., 270-M) par antenne (275-1, 275-2, ..., 275-M) et un DPD (260-1, 260-2, ..., 260-M) par chaîne radio (270-1, 270-2, ..., 270-M), le procédé étant réalisé par le nœud d'accès (200), le procédé comprenant :

l'obtention (S102) d'estimations de gain de canal par antenne parmi la pluralité d'antennes (275-1, 275-2, ..., 275-M) ;
la détermination (S104) de la taille, en termes de nombre de coefficients, de chaque DPD (260-1, 260-2, ..., 260-M) selon une fonction d'utilité qui dépend des estimations de gain de canal par antenne (275-1, 275-2, ..., 275-M) ; et
l'allocation (S106) du nombre déterminé de coefficients à chaque DPD (260-1, 260-2, ..., 260-M).

9. Procédé selon la revendication 8, dans lequel le procédé comprend en outre :

la sélection (S108) de valeurs des coefficients telles que déterminées pour chaque DPD (260-1, 260-2, ..., 260-M) ; et
la transmission (S110) d'un signal de liaison descendante depuis le nœud d'accès (200), dans lequel le signal de liaison descendante a subi une prédistorsion par les DPD (260-1, 260-2, ..., 260-M) selon les valeurs sélectionnées des coefficients.

10. Procédé selon l'une quelconque des revendications 8 et 9, dans lequel les estimations de gain de canal représentent des conditions de canal de moyenne mobile.

11. Procédé selon l'une quelconque des revendications 8 à 10, dans lequel les tailles de tous les DPD (260-1, 260-2, ..., 260-M) sont déterminées collectivement pour maximiser la fonction d'utilité, et/ou dans lequel les tailles des DPD (260-1, 260-2, ..., 260-M) sont, selon un modèle dynamique, déterminées de manière adaptative dans le temps sur la base de tailles précédemment déterminées des DPD (260-1, 260-2, ..., 260-M).

12. Procédé selon l'une quelconque des revendications 8 à 11, dans lequel la fonction d'utilité est limitée par un nombre total maximal de coefficients pouvant être alloués collectivement à tous les DPD (260-1, 260-2, ..., 260-M), dans lequel le nombre total maximal de coefficients dépend d'un budget de puissance disponible totale pour les DPD (260-1, 260-2, ..., 260-M) ou dans lequel le nombre total maximal de coefficients varie dans le temps, et/ou

dans lequel la fonction d'utilité dépend en outre de propriétés de composants matériels par chaîne radio (270-1, 270-2, ..., 270-M), et/ou dans lequel la fonction d'utilité est dérivée d'un critère d'optimisation, et dans lequel le critère d'optimisation concerne l'une quelconque parmi : une maximisation d'une capacité de liaison descendante du nœud d'accès (200), une minimisation d'une consommation de puissance des DPD (260-1, 260-2, ..., 260-M) pour une performance de système donnée du nœud d'accès (200), une maximisation d'une performance de système du nœud d'accès (200) pour une consommation de puissance donnée des DPD (260-1, 260-2, ..., 260-M).

13. Procédé selon l'une quelconque des revendications 8 à 12, dans lequel le nœud d'accès (200) obtient des estimations de gain de canal par antenne parmi la pluralité d'antennes (275-1, 275-2, ..., 275-M) pour une pluralité d'équipements utilisateurs (150-1, 150-2, 150-K) desservis par le nœud d'accès (200), et dans lequel la fonction d'utilité dépend d'une capacité de liaison descendante pour chacun des équipements utilisateurs (150-1, 150-2, 150-K).

14. Programme informatique (820) pour une détermination de taille de dispositif de prédistorsion numérique, DPD, d'un nœud d'accès (200), le nœud d'accès (200) étant configuré pour fonctionner dans un système à entrées multiples et sorties multiples, MIMO, massif numérique (100), le nœud d'accès (200) comprenant une pluralité d'antennes (275-1, 275-2, ..., 275-M), une chaîne radio (270-1, 270-2, ..., 270-M) par antenne (275-1, 275-2, ..., 275-M) et un DPD (260-1, 260-2, ..., 260-M) par chaîne radio (270-1, 270-2, ..., 270-M), le programme informatique comprenant un code informatique qui, lorsqu'il est exécuté sur une circuiterie de traitement (210) du nœud d'accès (200), amène le nœud d'accès (200) à :

obtenir (S102) des estimations de gain de canal par antenne parmi la pluralité d'antennes (275-1, 275-2, ..., 275-M) ;
déterminer (S104) la taille, en termes de nombre de coefficients, de chaque DPD (260-1, 260-2, ..., 260-M) selon une fonction d'utilité qui dépend des estimations de gain de canal par antenne (275-1, 275-2, ..., 275-M) ; et
allouer (S106) le nombre déterminé de coefficients à chaque DPD (260-1, 260-2, ..., 260-M).

15. Produit programme informatique (810) comprenant un programme informatique (820) selon la revendication 14, et un support de stockage lisible par ordinateur (830) sur lequel est stocké le programme informatique.

Fig. 1

Fig. 2

S102
Obtain channel gain estimates per antenna element

S104
Determine size of each DPD

S106
Allocate determined number of coefficients to each DPD

S108
Select values of the determined coefficients for each DPD

S110
Transmit downlink signal from access node

Fig. 3

| S201<br>Determine<br>channel<br>properties:<br><br>Measure<br>channel gain<br>of each<br>antenna | S202<br>Determine<br>budget:<br><br>DPD power<br>consumption<br>budget and<br>maximum<br>number of<br>DPD<br>coefficients | S203<br>Optimize per-<br>Antenna DPD<br>Sizes:<br><br>Allocate DPD<br>coefficients<br>based on<br>channel gain<br>of each<br>antenna | S204<br>Perform<br>transmission:<br><br>Adopt<br>optimized<br>DPD sizes for<br>each antenna<br>and perform<br>transmission |
| --- | --- | --- | --- |

Fig. 4

Fig. 5

Fig. 6

Fig. 7

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **K. HAUSMAIR** ; **P. N. LANDIN** ; **U. GUSTAVSSON** ; **C. FAGER** ; **T. ERIKSSON**. Digital predistortion for multi-antenna transmitters affected by antenna crosstalk. *IEEE Transactions on Microwave Theory and Techniques*, 2018, vol. 66 (3), 1524-1535
- OFDM-Based Beam-Oriented Digital Predistortion for Massive MIMO. **TARVER CHANCE et al.** 2019 IEEE INTERNATIONAL SYMPOSIUM ON CIRCUITS AND SYSTEMS (ISCAS). IEEE, 12 April 2021, 1-5

- Digital Predistortion for MIMO Transmitters Using Multi-Channel Error Feedback Adaptation. **LIU YING et al.** IEEE ACCESS. IEEE, 17 November 2020, vol. 8, 209345-209355
- **Y. LI** ; **A. ZHU**. On-demand real-time optimizable dynamic model sizing for digital predistortion of broadband RF power amplifiers. *IEEE Transactions on Microwave Theory and Techniques*, 2020, vol. 68 (7), 2891-2901